(19) Europäisches Patentamt / European Patent Office / Office européen des brevets

(11) **EP 4 341 712 B1**

(12) **EUROPÄISCHE PATENTSCHRIFT**

(45) Veröffentlichungstag und Bekanntmachung des Hinweises auf die Patenterteilung:
**18.06.2025 Patentblatt 2025/25**

(21) Anmeldenummer: **22712577.0**

(22) Anmeldetag: **10.03.2022**

(51) Internationale Patentklassifikation (IPC):
**B60L 3/12** (2006.01) **B60L 58/20** (2019.01)
**G01R 31/385** (2019.01) **G01R 31/389** (2019.01)

(52) Gemeinsame Patentklassifikation (CPC):
**G01R 31/389; B60L 3/12; B60L 58/20;**
**G01R 31/385;** B60L 2240/547; B60L 2240/549

(86) Internationale Anmeldenummer:
**PCT/EP2022/056251**

(87) Internationale Veröffentlichungsnummer:
**WO 2022/242928 (24.11.2022 Gazette 2022/47)**

(54) **VERFAHREN UND STEUERGERÄT ZUM BESTIMMEN EINER MAXIMALSTROMGRENZE EINES BATTERIESYSTEMS MIT MINDESTENS ZWEI BATTERIEN**

METHOD AND CONTROL DEVICE FOR DETERMINING A MAXIMUM CURRENT LIMIT OF A BATTERY SYSTEM HAVING AT LEAST TWO BATTERIES

PROCÉDÉ ET DISPOSITIF DE COMMANDE POUR DÉTERMINATION D'UNE LIMITE DE COURANT MAXIMALE D'UN SYSTÈME DE BATTERIES À AU MOINS DEUX BATTERIES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.05.2021 DE 102021205161**

(43) Veröffentlichungstag der Anmeldung:
**27.03.2024 Patentblatt 2024/13**

(73) Patentinhaber: **VOLKSWAGEN AKTIENGESELLSCHAFT**
**38440 Wolfsburg (DE)**

(72) Erfinder:
• **AUST, Stefan**
  **38108 Braunschweig (DE)**
• **HRAZDIRA, Adam**
  **12800 Prague 2 (CZ)**
• **VLCEK, Marian**
  **18600 Prague 8 (CZ)**
• **VALTR, Jiri**
  **17100 Prague 7 (CZ)**

(56) Entgegenhaltungen:
EP-A1- 2 765 673       US-A1- 2019 081 369
US-A1- 2019 214 837    US-A1- 2020 259 354

**Beschreibung**

Die Erfindung betrifft ein Verfahren und ein Steuergerät zum Bestimmen einer Maximalstromgrenze eines Batteriesystems mit mindestens zwei Batterien. Ferner betrifft die Erfindung ein Verfahren und eine Batteriesystemsteuerung zum Steuern eines Batteriesystems mit mindestens zwei Batterien.

Bei einem Batteriesystem mit mehreren parallel geschalteten Batterien sind die einzelnen Batterien in der Regel nicht exakt gleich und weisen daher auch nicht exakt die gleichen elektrischen Eigenschaften auf. Die Ursachen hierfür können Unterschiede bei der Herstellung und ein unterschiedliches Alterungsverhalten sein. Daher kann es auch bei einer Parallelschaltung von baugleichen Batterien zu einer unterschiedlichen Stromverteilung kommen. Beim Betrieb des Batteriesystems müssen in jedem Fall individuelle Stromgrenzen der einzelnen Batterien eingehalten werden.

US 2019/214837 A1 beschreibt ein verfahren zum begrenzen des Landestromes einer Batterie eines Batteriesystems mit zwei Batterien.

Der Erfindung liegt die Aufgabe zu Grunde, ein Verfahren und ein Steuergerät zum Bestimmen einer Maximalstromgrenze eines Batteriesystems mit mindestens zwei Batterien zu schaffen, mit denen die Maximalstromgrenze des Batteriesystems zuverlässig bestimmt werden kann.

Die Aufgabe wird erfindungsgemäß durch ein Verfahren mit den Merkmalen des Patentanspruchs 1 und ein Steuergerät mit den Merkmalen des Patentanspruchs 6 gelöst. Vorteilhafte Ausgestaltungen der Erfindung ergeben sich aus den Unteransprüchen. Insbesondere wird ein Verfahren zum Bestimmen einer Maximalstromgrenze eines Batteriesystems mit mindestens zwei Batterien zur Verfügung gestellt, wobei die folgenden Maßnahmen durchgeführt werden:

> Erfassen eines jeweiligen Einzelstromes an den mindestens zwei Batterien,
> Erfassen eines Gesamtstromes des Batteriesystems,
> Bestimmen eines jeweiligen Stromverhältnisses zwischen den erfassten Einzelströmen und dem erfassten Gesamtstrom,
> Bestimmen von maximalen Individualstromgrenzen des Batteriesystems jeweils für jede der mindestens zwei Batterien ausgehend von dem jeweils bestimmten Stromverhältnis und einer nominellen Maximalstromgrenze der jeweiligen Batterie;
> und/oder
> Empfangen oder Schätzen eines jeweiligen Einzelwiderstandes der mindestens zwei Batterien,
> Empfangen oder Schätzen eines Gesamtwiderstandes des Batteriesystems,
> Bestimmen eines jeweiligen Widerstandsverhältnisses zwischen den empfangenen oder geschätzten Einzelwiderständen und dem empfangenen oder geschätzten Gesamtwiderstand,
> Bestimmen von maximalen Individualstromgrenzen des Batteriesystems jeweils für jede der mindestens zwei Batterien ausgehend von dem jeweils bestimmten Widerstandsverhältnis und einer nominellen Maximalstromgrenze der jeweiligen Batterie;

Auswählen der kleinsten bestimmten maximalen Individualstromgrenze als Maximalstromgrenze des Batteriesystems,
Bereitstellen der bestimmten Maximalstromgrenze als Maximalstromgrenzensignal.

Ferner wird insbesondere ein Steuergerät zum Bestimmen einer Maximalstromgrenze eines Batteriesystems mit mindestens zwei Batterien geschaffen, wobei das Steuergerät dazu eingerichtet ist, die folgenden Maßnahmen durchzuführen:

> Empfangen eines jeweils an den mindestens zwei Batterien erfassten Einzelstromes,
> Empfangen eines erfassten Gesamtstromes des Batteriesystems,
> Bestimmen eines jeweiligen Stromverhältnisses zwischen den erfassten Einzelströmen und dem erfassten Gesamtstrom,
> Bestimmen von maximalen Individualstromgrenzen des Batteriesystems jeweils für jede der mindestens zwei Batterien ausgehend von dem jeweils bestimmten Stromverhältnis und einer nominellen Maximalstromgrenze der jeweiligen Batterie;
> und/oder
> Empfangen oder Schätzen eines jeweiligen Einzelwiderstandes der mindestens zwei Batterien,
> Empfangen oder Schätzen eines Gesamtwiderstandes des Batteriesystems,
> Bestimmen eines jeweiligen Widerstandsverhältnisses zwischen den empfangenen oder geschätzten Einzelwiderständen und dem empfangenen oder geschätzten Gesamtwiderstand,
> Bestimmen von maximalen Individualstromgrenzen des Batteriesystems jeweils für jede der mindestens zwei Batterien ausgehend von dem jeweils bestimmten Widerstandsverhältnis und einer nominellen Maximalstromgrenze der jeweiligen Batterie;

Auswählen der kleinsten bestimmten maximalen Individualstromgrenze als Maximalstromgrenze des Batteriesystems, Bereitstellen der bestimmten Maximalstromgrenze als Maximalstromgrenzensignal.

Das Verfahren und das Steuergerät ermöglichen es, eine Maximalstromgrenze über einen gesamten Betriebsbereich des Batteriesystems zuverlässig zu bestimmen. Hierbei können zwei Vorgehensweisen zum Einsatz kommen: Bei der ersten Vorgehensweise wird aus an den Batterien erfassten Einzelströmen und einem an dem Batteriesystem erfassten Gesamtstrom für jede der Batterien ein Stromverhältnis bestimmt. Ausgehend von dem jeweils bestimmten Stromverhältnis und einer nominellen Maximalstromgrenze wird für jede der Batterien eine maximale Individualstromgrenze des Batteriesystems bestimmt. Hiervon wird die kleinste der bestimmten maximalen Individualstromgrenzen ausgewählt. Dem liegt der Gedanke zugrunde, dass die hinsichtlich eines maximalen Stromes "schwächste" Batterie einen maximal möglichen Gesamtstrom des Batteriesystems definiert, da der maximale Strom dieser Batterie nicht überschritten werden darf. Bei der zweiten Vorgehensweise werden alternativ oder zusätzlich in ähnlicher Weise Widerstandsverhältnisse bestimmt und zum Bestimmen von maximalen Individualstromgrenzen verwendet. Die jeweiligen Ergebnisse können insbesondere auch zusammengefasst und miteinander kombiniert werden. Die erste Vorgehensweise funktioniert besonders gut bei großen Strömen, wohingegen die zweite Vorgehensweise von Vorteil ist bei kleineren Strömen, bei denen ein Fehler beim Erfassen der Ströme größer ist, sodass ein Signal-zu-Rausch-Verhältnis sinkt.

Die Batterien des Batteriesystems sind insbesondere parallel geschaltet. An jeder der Batterien kann ein Einzelstrom mittels eines Stromsensors erfasst werden. Ferner wird auch ein Gesamtstrom des Batteriesystems, insbesondere mittels eines Stromsensors, erfasst. Jede der Batterien weist eine vorgegebene nominelle Maximalstromgrenze auf.

Teile des Steuergeräts können einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) oder feldprogrammierbares Gatterfeld (FPGA) ausgebildet sind.

Die beiden Vorgehensweisen werden nachfolgend beispielhaft erläutert. Beispielhaft wird hierzu ein Batteriesystem mit zwei parallel geschalteten Batterien betrachtet.

Für die Batterien sind beispielsweise die folgenden nominellen Maximalstromgrenzen vorgegeben:

$$I_{1,max} = 150 \text{ A}$$

$$I_{2,max} = 150 \text{ A}$$

Die erfassten Einzelströme und ein Gesamtstrom sind beispielsweise:

$$I_{system} = 200 \text{ A}$$

$$I_1 = 110 \text{ A}$$

$$I_2 = 90 \text{ A}$$

Hieraus ergeben sich die folgenden Stromverhältnisse:

$$Ratio_{1,I} = I_{system} / I_1 = 200 \text{ A} / 110 \text{ A} = 1{,}81$$

$$Ratio_{2,I} = I_{system} / I_2 = 200 \text{ A} / 90 \text{ A} = 2{,}22$$

Hieraus ergeben sich die folgenden maximalen Individualstromgrenzen:

$$I_{1,maxsystem,I} = Ratio_{1,I} \cdot I_{1,max} = 1{,}81 \cdot 150 \text{ A} = 271{,}5 \text{ A}$$

$$I_{2,maxsystem,I} = Ratio_{2,I} \cdot I_{2,max} = 2{,}22 \cdot 150 \text{ A} = 333 \text{ A}$$

Hiervon wird die kleinste bestimmte maximale Individualstromgrenze als Maximalstromgrenze des Batteriesystems ausgewählt:

$$I_{max,system,I} = min\_n(I_{n,maxsystem,I}) = min(I_{1,maxsystem,I}; I_{2,maxsystem,I})$$
$$= min(271{,}5 \text{ A}, 333 \text{ A}) = 271{,}5 \text{ A}$$

In dem Beispiel wäre die erste Batterie die hinsichtlich eines maximalen Stroms "schwächere" Batterie, sodass ein Gesamtstrom des Batteriesystems in Abhängigkeit dieser Batterie auf einen maximalen Strom von 271,5 A begrenzt werden muss, damit eine nominelle Maximalstromgrenze dieser Batterie nicht überschritten wird. Im Vergleich zu einer nominellen Maximalstromgrenze des Batteriesystems von 150 A + 150 A = 300 A, ist die bestimmte Maximalstromgrenze kleiner. Würde ein Gesamtstrom von 271,5 A, das heißt bis zur bestimmten Maximalstromgrenze, aus dem Batteriesystem bereitgestellt, so stellt die erste ("schwächere") Batterie einen Strom an ihrer nominellen Maximalstromgrenze von 150 A bereit, während die zweite Batterie nur 121,5 A bereitstellt.

In der zweiten Vorgehensweise werden Einzelwiderstände der beiden Batterien und ein Gesamtwiderstand empfangen, welche beispielsweise die folgenden Werte aufweisen:

$$R_{system} = 50 \text{ m}\Omega$$

$$R_1 = 90 \text{ m}\Omega$$

$$R_2 = 110 \text{ m}\Omega$$

Die Werte können beispielsweise von einer Batteriesteuerung nach an sich bekannten Verfahren geschätzt werden und von dieser dem Steuergerät bereitgestellt werden.

Hieraus ergeben sich die folgenden Widerstandsverhältnisse:

$$Ratio_{1,R} = R_1 / R_{system} = 90 \text{ m}\Omega / 50 \text{ m}\Omega = 1{,}8$$

$$Ratio_{2,R} = R_2 / R_{system} = 110 \text{ m}\Omega / 50 \text{ m}\Omega = 2{,}2$$

Hieraus ergeben sich die folgenden maximalen Individualstromgrenzen:

$$I_{1,maxsystem,R} = Ratio_{1,R} \cdot I_{1,max} = 1{,}8 \cdot 150 \text{ A} = 270 \text{ A}$$

$$I_{2,maxsystem,R} = Ratio_{2,R} \cdot I_{2,max} = 2{,}2 \cdot 150 \text{ A} = 330 \text{ A}$$

Hiervon wird die kleinste bestimmte maximale Individualstromgrenze als Maximalstromgrenze des Batteriesystems ausgewählt:

$$I_{max,system,R} = min\_n(I_{n,maxsystem,R}) = min(I_{1,maxsystem,R}; I_{2,maxsystem,R})$$
$$= min(270 \text{ A}, 330 \text{ A}) = 270 \text{ A}$$

Die Ergebnisse der ersten Vorgehensweise und der zweiten Vorgehensweise sind also fast gleich. Die Beispiele dienen der Verdeutlichung der Erfindung. Grundsätzlich können die Werte auch anders sein. Insbesondere kann das Batteriesystem auch mehr als zwei Batterien aufweisen. Die grundsätzliche Vorgehensweise ist aber auch bei mehr als zwei Batterien die gleiche.

In einer Ausführungsform ist vorgesehen, dass ein gewichteter Mittelwert aus dem jeweiligen Stromverhältnis und Widerstandsverhältnis gebildet wird, wobei die maximalen Individualstromgrenzen ausgehend von dem jeweiligen gewichteten Mittelwert bestimmt werden. Anders ausgedrückt werden das Stromverhältnis und das Widerstandsverhältnis zusammengefasst durch eine gewichtete Mittelwertbildung, welche auch in Form einer Interpolation zwischen den beiden Verhältnissen ausgeführt werden kann. Dies erfolgt insbesondere für jede Batterie, bevor die maximalen Individualstromgrenzen bestimmt werden. Hierdurch kann insbesondere eine benötigte Rechenleistung eingespart werden. Die Gewichtungsfaktoren erlauben ein Parametrieren der Mittelwertbildung bzw. der Interpolation. Die Gewichtungsfaktoren können beispielsweise empirisch für unterschiedliche Lastszenarien bestimmt und vorgehalten werden.

Das obige Beispiel aufgreifend ergibt sich dann mit einem Gewichtungsfaktor w für jede Batterie:

$$\text{Ratio}_{n,\text{gewichtet}} = w \cdot \text{Ratio}_{n,I} + (1 - w) \cdot \text{Ratio}_{n,R}$$

In einer weiterbildenden Ausführungsform ist vorgesehen, dass Gewichtungsfaktoren beim Bilden des gewichteten Mittelwertes in Abhängigkeit des Gesamtstroms gewählt werden. Hierdurch können für unterschiedliche Bereiche des Gesamtstroms unterschiedliche Gewichtungsfaktoren gewählt werden. Es kann vorgesehen sein, dass die Gewichtungsfaktoren als Funktion des Gesamtstroms bestimmt werden. Insbesondere ist vorgesehen, dass die Gewichtungsfaktoren derart gewählt werden, dass in einem unteren Bereich des Gesamtstroms ein Anteil des Widerstandsverhältnisses überwiegt, wohingegen im oberen Bereich des Gesamtstroms ein Anteil des Stromverhältnisses überwiegt. Hierdurch können Fehler aufgrund eines bei kleinen Strömen schlechteren Signal-zu-Rausch-Verhältnisses beim Erfassen der Ströme verringert werden. Insgesamt verbessert sich hierdurch das Bestimmen der Maximalstromgrenze.

In einer Ausführungsform ist vorgesehen, dass die Stromverhältnisse und/oder Widerstandsverhältnisse und/oder gewichteten Mittelwerte zeitlich mittels eines Tiefpassfilters gefiltert werden, wobei die maximalen Individualstromgrenzen ausgehend von den gefilterten Verhältnissen und/oder gefilterten gewichteten Mittelwerten bestimmt werden. Hierdurch kann ein zeitlicher Verlauf der Stromverhältnisse und/oder Widerstandsverhältnisse geglättet werden.

Das obige Beispiel aufgreifend ergibt sich dann (für die gewichteten Mittelwerte):

$$\text{Ratio}_{n,\text{gewichtet,geglättet}} = \text{Tiefpass} (\text{Ratio}_{n,\text{gewichtet}}, \tau)$$

Hierbei ist $\tau$ ein Glättungskoeffizient gemäß der jeweiligen Implementierung des Tiefpassfilters.

Weitere Merkmale zur Ausgestaltung des Steuergeräts ergeben sich aus der Beschreibung von Ausgestaltungen des Verfahrens. Die Vorteile des Steuergeräts sind hierbei jeweils die gleichen wie bei den Ausgestaltungen des Verfahrens.

Ferner wird insbesondere auch ein Verfahren zum Steuern eines Batteriesystems mit mindestens zwei Batterien zur Verfügung gestellt, wobei ein Verfahren nach einem der voranstehenden Ausführungsformen ausgeführt wird, und wobei ein Strom des Batteriesystems ausgehend von der bestimmten Maximalstromgrenze begrenzt wird. Dies ermöglicht das aktive Begrenzen des Gesamtstroms des Batteriesystems gemäß der bestimmten Maximalstromgrenze.

Weiter wird insbesondere auch eine Batteriesystemsteuerung geschaffen, umfassend mindestens ein Steuergerät nach einer der voranstehend beschriebenen Ausführungsformen, wobei die Batteriesystemsteuerung dazu eingerichtet ist, einen Strom des Batteriesystems ausgehend von einer mittels des Steuergeräts bestimmten Maximalstromgrenze zu begrenzen.

Das Steuergerät und die Batteriesystemsteuerung können insbesondere in einem Fahrzeug, insbesondere in einem Kraftfahrzeug, verwendet werden. Daher wird auch ein Fahrzeug vorgeschlagen, umfassend mindestens ein Steuergerät gemäß einer der beschriebenen Ausführungsformen und/oder umfassend mindestens eine Batteriesystemsteuerung. Grundsätzlich können das Verfahren und die Batteriesystemsteuerung aber auch bei anderen mobilen oder stationären Batteriesystemen eingesetzt werden.

Nachfolgend wird die Erfindung anhand bevorzugter Ausführungsbeispiele unter Bezugnahme auf die Figuren näher erläutert. Hierbei zeigen:

Fig. 1    eine schematische Darstellung einer Ausführungsform des Steuergeräts zum Bestimmen einer Maximalstromgrenze eines Batteriesystems mit mindestens zwei Batterien;

Fig. 2    eine schematische Darstellung einer weiteren Ausführungsform des Steuergeräts;

Fig. 3    eine schematische Darstellung einer weiteren Ausführungsform des Steuergeräts.

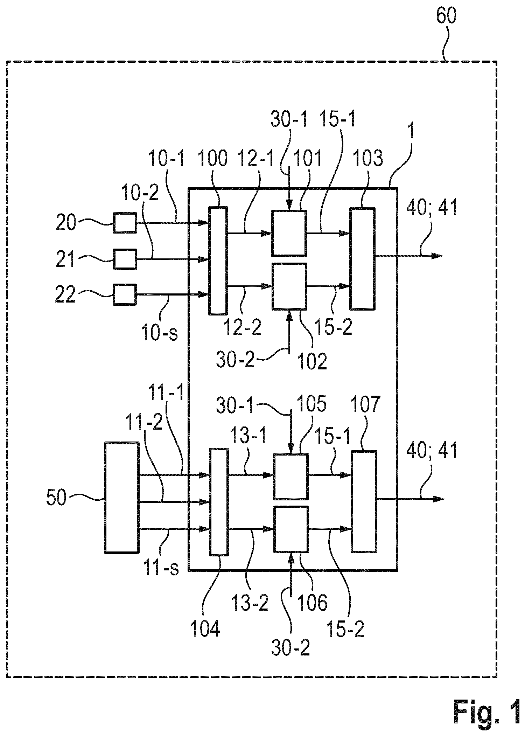

In der Fig. 1 ist eine schematische Darstellung einer Ausführungsform des Steuergeräts 1 zum Bestimmen einer Maximalstromgrenze 40 eines Batteriesystems mit zwei Batterien gezeigt. Das Steuergerät 1 führt insbesondere das in dieser Offenbarung beschriebene Verfahren aus, das anhand des Steuergeräts 1 erläutert wird.

Das Steuergerät 1 umfasst die Module 100 bis 103. Die Module 100 bis 103 können als eine Kombination von Hardware und Software ausgebildet sein, beispielsweise als Programmcode, der auf einem Mikrocontroller oder Mikroprozessor ausgeführt wird.

Dem Steuergerät 1 werden jeweils an Batterien des Batteriesystems erfasste Einzelströme 10-1, 10-2 und ein Gesamtstrom 10-s des Batteriesystems zugeführt. Die Ströme 10-x werden mittels Stromsensoren 20, 21, 22 erfasst und beispielsweise als Stromsignale bereitgestellt.

In dem Modul 100 bestimmt das Steuergerät 1 ein jeweiliges Stromverhältnis 12-1, 12-2 zwischen den erfassten Einzelströmen 10-1, 10-2 und dem erfassten Gesamtstrom 10-s.

In den Modulen 101 und 102 bestimmt das Steuergerät 1 maximale Individualstromgrenzen 15-1, 15-2 des Batteriesystems jeweils für jede der beiden Batterien ausgehend von dem jeweils bestimmten Stromverhältnis 12-1, 12-2

und einer nominellen Maximalstromgrenze 30-1, 30-2 der jeweiligen Batterie.

In dem Modul 103 wählt das Steuergerät 1 die kleinste bestimmte maximale Individualstromgrenze als Maximalstromgrenze 40 des Batteriesystems aus und stellt diese als Maximalstromgrenzensignal 41 bereit.

Alternativ oder zusätzlich kann vorgesehen sein, dass das Steuergerät 1 die Module 104-107 umfasst.

Dem Steuergerät 1 werden dann alternativ oder zusätzlich jeweilige (aktuelle) Einzelwiderstände 11-1, 11-2 der beiden Batterien des Batteriesystems und ein (aktueller) Gesamtwiderstand 11-s des Batteriesystems zugeführt. Die Widerstände 11-1, 11-2, 11-s können beispielsweise von einer Batteriesteuerung 50 bereitgestellt und übermittelt werden oder auf sonstige Weise geschätzt werden.

In dem Modul 104 bestimmt das Steuergerät 1 ein jeweiliges Widerstandsverhältnis 13-1, 13-2 zwischen den empfangenen oder geschätzten Einzelwiderständen 11-1, 11-2 und dem empfangenen oder geschätzten Gesamtwiderstand 11-s.

In den Modulen 105 und 106 bestimmt das Steuergerät 1 maximale Individualstromgrenzen 15-1, 15-2 des Batteriesystems jeweils für jede der beiden Batterien ausgehend von dem jeweils bestimmten Widerstandsverhältnis 13-1, 13-2 und der nominellen Maximalstromgrenze 30-1, 30-2 der jeweiligen Batterie.

In dem Modul 107 wählt das Steuergerät 1 die kleinste bestimmte maximale Individualstromgrenze als Maximalstromgrenze 40 des Batteriesystems aus und stellt diese als Maximalstromgrenzensignal 41 bereit.

Die von den Modulen 103 und 107 gelieferten Ergebnisse können auch zusammengefasst werden.

Das Steuergerät 1 kann Teil einer Batteriesystemsteuerung 60 sein, wobei die Batteriesystemsteuerung 60 dazu eingerichtet ist, einen Gesamtstrom 10-s des Batteriesystems ausgehend von der mittels des Steuergeräts 1 bestimmten Maximalstromgrenze 40 zu begrenzen. Hierzu wird in der Batteriesystemsteuerung 60 insbesondere das Maximalstromgrenzensignal 41 ausgewertet und verwendet.

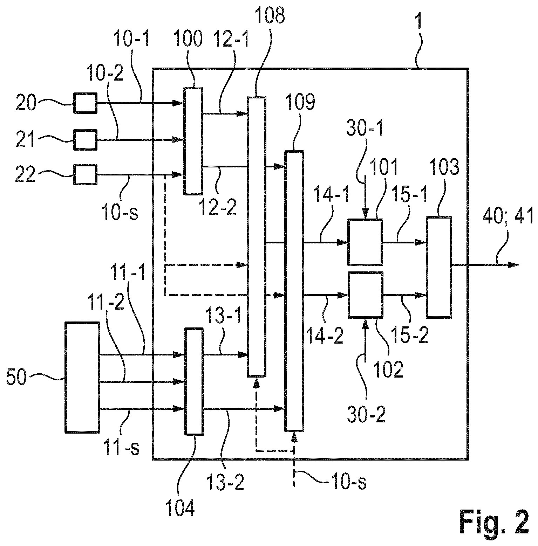

In Fig. 2 ist eine weitere Ausführungsform des Steuergeräts 1 gezeigt. Die Ausführungsform ist grundsätzlich wie die in der Fig. 1 gezeigte Ausführungsform ausgestaltet. Gleiche Bezugszeichen bezeichnen gleiche Merkmale und Begriffe.

Zusätzlich ist vorgesehen, dass ein gewichteter Mittelwert 14-1, 14-2 aus dem jeweiligen Stromverhältnis 12-1, 12-2 und Widerstandsverhältnis 13-1, 13-2 gebildet wird, wobei die maximalen Individualstromgrenzen 15-1, 15-2 ausgehend von dem jeweiligen gewichteten Mittelwert 14-1, 14-2 bestimmt werden. Hierzu weist das Steuergerät 1 zusätzlich die Module 108 und 109 auf, welche die gewichtete Mittelung durch Interpolation zwischen dem jeweiligen Stromverhältnis 12-1, 12-2 und dem jeweiligen Widerstandsverhältnis 13-1, 13-2 durchführen.

Es kann vorgesehen sein, dass Gewichtungsfaktoren beim Bilden des gewichteten Mittelwertes 14-1, 14-2 in den Modulen 108 und 109 in Abhängigkeit des Gesamtstroms 10-s, insbesondere als Funktion des Gesamtstroms 10-s, gewählt werden.

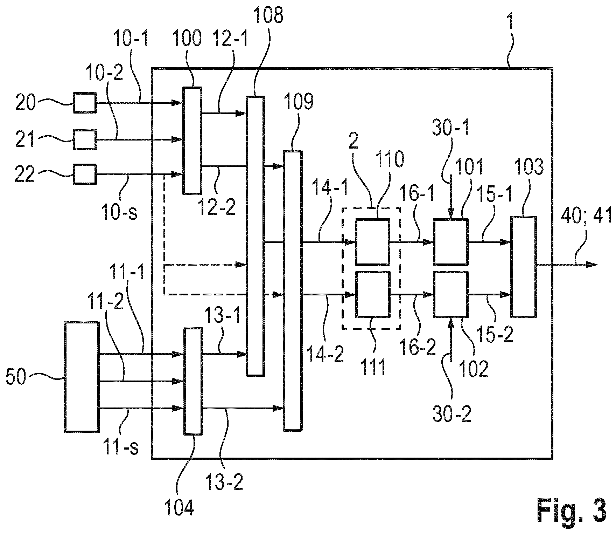

In Fig. 3 ist eine weitere Ausführungsform des Steuergeräts 1 gezeigt. Die Ausführungsform ist grundsätzlich wie die in der Fig. 2 gezeigte Ausführungsform ausgestaltet. Gleiche Bezugszeichen bezeichnen gleiche Merkmale und Begriffe.

Zusätzlich ist vorgesehen, dass die gewichteten Mittelwerte 14-1, 14-2 in den Modulen 110 und 111 zeitlich mittels eines Tiefpassfilters gefiltert werden, wobei die maximalen Individualstromgrenzen 15-1, 15-2 ausgehend von den gefilterten gewichteten Mittelwerten 16-1, 16-2 bestimmt werden. Die Module 110 und 111 bilden insbesondere eine Filtereinrichtung 2.

Alternativ können auch bereits die Verhältnisse 12-1, 12-2, 13-1, 13-2 mittels des Tiefpassfilters gefiltert werden (nicht gezeigt), wobei das Filtern der gewichteten Mittelwerte 14-1, 14-2 im Hinblick auf eine benötigte Hardware und/oder eine benötigte Rechenleistung vorteilhaft ist.

**Bezugszeichenliste**

| | |
|---|---|
| 1 | Steuergerät |
| 2 | Filtereinrichtung |
| 10-1 | Einzelstrom |
| 10-2 | Einzelstrom |
| 10-s | Gesamtstrom |
| 11-1 | Einzelwiderstand |
| 11-2 | Einzelwiderstand |
| 11-s | Gesamtwiderstand |
| 12-1 | Stromverhältnis |
| 12-2 | Stromverhältnis |
| 13-1 | Widerstandsverhältnis |

| 13-2 | Widerstandsverhältnis |
|------|------------------------|
| 14-1 | gewichteter Mittelwert |
| 14-2 | gewichteter Mittelwert |
| 15-1 | maximale Individualstromgrenze |
| 15-2 | maximale Individualstromgrenze |
| 16-1 | gefilterter gewichteter Mittelwert |
| 16-2 | gefilterter gewichteter Mittelwert |
| 20 | Stromsensor |
| 21 | Stromsensor |
| 22 | Stromsensor |
| 30-1 | nominelle Maximalstromgrenze |
| 30-2 | nominelle Maximalstromgrenze |
| 40 | Maximalstromgrenze |
| 41 | Maximalstromgrenzensignal |
| 50 | Batteriesteuerung |
| 60 | Batteriesystemsteuerung |
| 100-111 | Module des Steuergeräts |

**Patentansprüche**

1. Verfahren zum Bestimmen einer Maximalstromgrenze (40) eines Batteriesystems mit mindestens zwei Batterien,

   wobei die folgenden Maßnahmen durchgeführt werden:

   Erfassen eines jeweiligen Einzelstromes (10-1,10-2) an den mindestens zwei Batterien,
   Erfassen eines Gesamtstromes (10-s) des Batteriesystems,
   Bestimmen eines jeweiligen Stromverhältnisses (12-1,12-2) zwischen den erfassten Einzelströmen (10-1,10-2) und dem erfassten Gesamtstrom (10-s),
   Bestimmen von maximalen Individualstromgrenzen (15-1,15-2) des Batteriesystems jeweils für jede der mindestens zwei Batterien ausgehend von dem jeweils bestimmten Stromverhältnis (12-1,12-2) und einer nominellen Maximalstromgrenze (30-1,30-2) der jeweiligen Batterie;
   und/oder
   Empfangen oder Schätzen eines jeweiligen Einzelwiderstandes (11-1,11-2) der mindestens zwei Batterien,
   Empfangen oder Schätzen eines Gesamtwiderstandes (11-s) des Batteriesystems, Bestimmen eines jeweiligen Widerstandsverhältnisses (13-1,13-2) zwischen den empfangenen oder geschätzten Einzelwiderständen (11-1,11-2) und dem empfangenen oder geschätzten Gesamtwiderstand (11-s),
   Bestimmen von maximalen Individualstromgrenzen (15-1,15-2) des Batteriesystems jeweils für jede der mindestens zwei Batterien ausgehend von dem jeweils bestimmten Widerstandsverhältnis (13-1,13-2) und einer nominellen Maximalstromgrenze (30-1,30-2) der jeweiligen Batterie;

   Auswählen der kleinsten bestimmten maximalen Individualstromgrenze (15-1,15-2) als Maximalstromgrenze (40) des Batteriesystems,
   Bereitstellen der bestimmten Maximalstromgrenze (40) als Maximalstromgrenzensignal (41).

2. Verfahren nach Anspruch 1, **dadurch gekennzeichnet, dass** ein gewichteter Mittelwert (14-1,14-2) aus dem jeweiligen Stromverhältnis (12-1,12-2) und Widerstandsverhältnis (13-1,13-2) gebildet wird, wobei die maximalen Individualstromgrenzen (15-1,15-2) ausgehend von dem jeweiligen gewichteten Mittelwert (14-1,14-2) bestimmt werden.

3. Verfahren nach Anspruch 2, **dadurch gekennzeichnet, dass** Gewichtungsfaktoren beim Bilden des gewichteten Mittelwertes (14-1,14-2) in Abhängigkeit des Gesamtstroms (11-s) gewählt werden.

4. Verfahren nach einem der Ansprüche 1 bis 3, **dadurch gekennzeichnet, dass** die Stromverhältnisse (12-1,12-2) und/oder Widerstandsverhältnisse (13-1,13-2) und/oder gewichteten Mittelwerte (14-1,14-2) zeitlich mittels eines Tiefpassfilters gefiltert werden, wobei die maximalen Individualstromgrenzen (15-1,15-2) ausgehend von den gefilterten Verhältnissen und/oder gefilterten gewichteten Mittelwerten (16-1,16-2) bestimmt werden.

5. Verfahren zum Steuern eines Batteriesystems mit mindestens zwei Batterien, wobei ein Verfahren nach einem der Ansprüche 1 bis 4 ausgeführt wird, und wobei einen Gesamtstrom (60) des Batteriesystems ausgehend von der bestimmten Maximalstromgrenze (40) begrenzt wird.

6. Steuergerät (1) zum Bestimmen einer Maximalstromgrenze (40) eines Batteriesystems mit mindestens zwei Batterien, wobei das Steuergerät (1) dazu eingerichtet ist,

die folgenden Maßnahmen durchzuführen:

Empfangen eines jeweils an den mindestens zwei Batterien erfassten Einzelstromes (10-1,10-2),
Empfangen eines erfassten Gesamtstromes (11-s) des Batteriesystems,
Bestimmen eines jeweiligen Stromverhältnisses (12-1,12-2) zwischen den erfassten Einzelströmen (10-1,10-2) und dem erfassten Gesamtstrom (10-s),
Bestimmen von maximalen Individualstromgrenzen (15-1,15-2) des Batteriesystems jeweils für jede der mindestens zwei Batterien ausgehend von dem jeweils bestimmten Stromverhältnis (12-1,12-2) und einer nominellen Maximalstromgrenze (30-1,30-2) der jeweiligen Batterie;
und/oder
Empfangen oder Schätzen eines jeweiligen Einzelwiderstandes (11-1,11-2) der mindestens zwei Batterien, Empfangen oder Schätzen eines Gesamtwiderstandes (11-s) des Batteriesystems, Bestimmen eines jeweiligen Widerstandsverhältnisses (13-1,13-2) zwischen den empfangenen oder geschätzten Einzelwiderständen (11-1,11-2) und dem empfangenen oder geschätzten Gesamtwiderstand (11-s),
Bestimmen von maximalen Individualstromgrenzen (15-1,15-2) des Batteriesystems jeweils für jede der mindestens zwei Batterien ausgehend von dem jeweils bestimmten Widerstandsverhältnis (13-1,13-2) und einer nominellen Maximalstromgrenze (30-1,30-2) der jeweiligen Batterie;

Auswählen der kleinsten bestimmten maximalen Individualstromgrenze (15-1,15-2) als Maximalstromgrenze (40) des Batteriesystems,
Bereitstellen der bestimmten Maximalstromgrenze (40) als Maximalstromgrenzensignal (41).

7. Steuergerät (1) nach Anspruch 6, **dadurch gekennzeichnet, dass** das Steuergerät (1) ferner dazu eingerichtet ist, einen gewichteten Mittelwert (14-1,14-2) aus dem jeweiligen Stromverhältnis (12-1,12-2) und Widerstandsverhältnis (13-1,13-2) zu bilden und die maximalen Individualstromgrenzen (15-1,15-2) ausgehend von dem jeweiligen gewichteten Mittelwert (14-1,14-2) zu bestimmen.

8. Steuergerät (1) nach Anspruch 7, **dadurch gekennzeichnet, dass** das Steuergerät (1) ferner dazu eingerichtet ist, Gewichtungsfaktoren beim Bilden des gewichteten Mittelwertes (14-1,14-2) in Abhängigkeit des Gesamtstroms (10-s) zu wählen.

9. Steuergerät (1) nach einem der Ansprüche 6 bis 8, **dadurch gekennzeichnet, dass** das Steuergerät (1) eine Filtereinrichtung (2) aufweist, die dazu eingerichtet ist, die Stromverhältnisse (12-1,12-2) und/oder Widerstandsverhältnisse (13-1,13-2) und/oder gewichteten Mittelwerte (14-1,14-2) zeitlich mittels eines Tiefpassfilters zu filtern, wobei das Steuergerät (1) ferner dazu eingerichtet ist, die maximalen Individualstromgrenzen (15-1,15-2) ausgehend von den gefilterten Verhältnissen und/oder gefilterten gewichteten Mittelwerten (16-1,16-2) zu bestimmen.

10. Batteriesystemsteuerung (60), umfassend mindestens ein Steuergerät (1) nach einem der Ansprüche 6 bis 9, wobei die Batteriesystemsteuerung (60) dazu eingerichtet ist, einen Gesamtstrom (10-s) des Batteriesystems ausgehend von einer mittels des Steuergeräts (1) bestimmten Maximalstromgrenze (40) zu begrenzen.

## Claims

1. Method for determining a maximum current limit (40) of a battery system comprising at least two batteries, wherein the following actions are carried out:

recording a relevant individual current (10-1,10-2) at the at least two batteries,
recording a total current (10-s) of the battery system,
determining a relevant current ratio (12-1,12-2) between the recorded individual currents (10-1,10-2) and the recorded total current (10-s),
determining maximum individual current limits (15-1,15-2) of the battery system for each of the at least two batteries based on the respectively determined current ratio (12-1,12-2) and a nominal maximum current limit (30-1,30-2) of the relevant battery;

and/or

receiving or estimating a relevant individual resistance (11-1,11-2) of the at least two batteries,

receiving or estimating a total resistance (11-s) of the battery system,

determining a relevant resistance ratio (13-1,13-2) between the received or estimated individual resistances (11-1,11-2) and the received or estimated total resistance (11-s),

determining maximum individual current limits (15-1,15-2) of the battery system for each of the at least two batteries based on the respectively determined resistance ratio (13-1,13-2) and a nominal maximum current limit (30-1,30-2) of the relevant battery;

selecting the smallest determined maximum individual current limit (15-1,15-2) as the maximum current limit (40) of the battery system,

providing the determined maximum current limit (40) as a maximum current limit signal (41).

2. Method according to claim 1, **characterized in that** a weighted mean value (14-1,14-2) is formed from the relevant current ratio (12-1,12-2) and resistance ratio (13-1,13-2), the maximum individual current limits (15-1,15-2) being determined based on the relevant weighted mean value (14-1,14-2).

3. Method according to claim 2, **characterized in that** weighting factors are selected depending on the total current (11-s), when forming the weighted mean value (14-1,14-2).

4. Method according to any of claims 1 to 3, **characterized in that** the current ratios (12-1,12-2) and/or resistance ratios (13-1,13-2) and/or weighted mean values (14-1,14-2) are temporally filtered by means of a low-pass filter, the maximum individual current limits (15-1,15-2) being determined based on the filtered ratios and/or filtered weighted mean values (16-1,16-2).

5. Method for controlling a battery system comprising at least two batteries, wherein a method according to any of claims 1 to 4 is carried out, and wherein a total current (60) of the battery system is limited based on the determined maximum current limit (40).

6. Control unit (1) for determining a maximum current limit (40) of a battery system comprising at least two batteries, wherein the control unit (1) is configured to carry out the following actions:

receiving an individual current (10-1, 10-2) recorded at each of the at least two batteries,

receiving a recorded total current (11-s) of the battery system,

determining a relevant current ratio (12-1,12-2) between the recorded individual currents (10-1,10-2) and the recorded total current (10-s),

determining maximum individual current limits (15-1,15-2) of the battery system for each of the at least two batteries based on the respectively determined current ratio (12-1,12-2) and a nominal maximum current limit (30-1,30-2) of the relevant battery;

and/or

receiving or estimating a relevant individual resistance (11-1,11-2) of the at least two batteries,

receiving or estimating a total resistance (11-s) of the battery system,

determining a relevant resistance ratio (13-1,13-2) between the received or estimated individual resistances (11-1,11-2) and the received or estimated total resistance (11-s),

determining maximum individual current limits (15-1,15-2) of the battery system for each of the at least two batteries based on the respectively determined resistance ratio (13-1,13-2) and a nominal maximum current limit (30-1,30-2) of the relevant battery;

selecting the smallest determined maximum individual current limit (15-1,15-2) as the maximum current limit (40) of the battery system,

providing the determined maximum current limit (40) as a maximum current limit signal (41).

7. Control unit (1) according to claim 6, **characterized in that** the control unit (1) is further configured to form a weighted mean value (14-1,14-2) from the relevant current ratio (12-1,12-2) and resistance ratio (13-1,13-2) and to determine the maximum individual current limits (15-1,15-2) based on the relevant weighted mean value (14-1,14-2).

8. Control unit (1) according to claim 7, **characterized in that** the control unit (1) is further configured to select weighting factors depending on the total current (10-s), when forming the weighted mean value (14-1,14-2).

9. Control unit (1) according to any of claims 6 to 8, **characterized in that** the control unit (1) comprises a filter device (2) which is configured to temporally filter the current ratios (12-1, 12-2) and/or resistance ratios (13-1, 13-2) and/or weighted mean values (14-1, 14-2) by means of a low-pass filter, the control unit (1) being further configured to determine the maximum individual current limits (15-1, 15-2) based on the filtered ratios and/or filtered weighted mean values (16-1, 16-2).

10. Battery system controller (60) comprising at least one control unit (1) according to any of claims 6 to 9, wherein the battery system controller (60) is configured to limit a total current (10-s) of the battery system based on a maximum current limit (40) determined by means of the control unit (1).

**Revendications**

1. Procédé de détermination d'une limite de courant maximale (40) d'un système de batteries comprenant au moins deux batteries,
   dans lequel les mesures suivantes sont réalisées :

   détection d'un courant individuel (10-1, 10-2) respectif sur les au moins deux batteries,
   détection d'un courant total (10-s) du système de batteries,
   détermination d'un rapport de courant (12-1, 12-2) respectif entre les courants individuels (10-1, 10-2) détectés et le courant total (10-s) détecté,
   détermination de limites de courant individuel maximales (15-1, 15-2) du système de batteries, respectivement pour chacune des au moins deux batteries, en se basant sur le rapport de courant (12-1, 12-2) respectivement déterminé et sur une limite de courant maximale nominale (30-1, 30-2) de la batterie respective ;
   et/ou
   réception ou estimation d'une résistance individuelle (11-1, 11-2) respective des au moins deux batteries,
   réception ou estimation d'une résistance totale (11-s) du système de batteries,
   détermination d'un rapport de résistance (13-1, 13-2) respectif entre les résistances individuelles (11-1, 11-2) reçues ou estimées et la résistance totale (11-s) reçue ou estimée,
   détermination de limites de courant individuel maximales (15-1, 15-2) du système de batteries, respectivement pour chacune des au moins deux batteries, à partir du rapport de résistance (13-1, 13-2) respectivement déterminé et d'une limite de courant maximale nominale (30-1, 30-2) de la batterie respective ;
   sélection de la plus petite limite de courant individuel maximale (15-1, 15-2) déterminée comme limite de courant maximale (40) du système de batteries,
   fourniture de la limite de courant maximale (40) déterminée en tant que signal de limite de courant maximale (41).

2. Procédé selon la revendication 1, **caractérisé en ce qu'**une valeur moyenne pondérée (14-1, 14-2) est formée à partir du rapport de courant (12-1, 12-2) et du rapport de résistance (13-1, 13-2) respectifs, dans lequel les limites de courant individuel maximales (15-1, 15-2) sont déterminées à partir de la valeur moyenne pondérée (14-1, 14-2) respective.

3. Procédé selon la revendication 2, **caractérisé en ce que** des facteurs de pondération sont choisis lors de la formation de la valeur moyenne pondérée (14-1, 14-2) en fonction du courant total (11-s).

4. Procédé selon l'une des revendications 1 à 3, **caractérisé en ce que** les rapports de courant (12-1, 12-2) et/ou les rapports de résistance (13-1, 13-2) et/ou les valeurs moyennes pondérées (14-1, 14-2) sont filtrés temporellement au moyen d'un filtre passe-bas, dans lequel les limites de courant individuel maximales (15-1, 15-2) sont déterminées à partir des rapports filtrés et/ou des valeurs moyennes pondérées filtrées (16-1, 16-2).

5. Procédé de commande d'un système de batteries comportant au moins deux batteries, dans lequel un procédé selon l'une des revendications 1 à 4 est mis en œuvre, et dans lequel un courant total (60) du système de batteries est limité à partir de la limite de courant maximale (40) déterminée.

6. Appareil de commande (1) permettant de déterminer une limite de courant maximale (40) d'un système de batteries comportant au moins deux batteries, dans lequel l'appareil de commande (1) est conçu pour réaliser les mesures suivantes :

   réception d'un courant individuel (10-1, 10-2) détecté respectivement sur les au moins deux batteries,

réception d'un courant total (11-s) détecté du système de batteries,

détermination d'un rapport de courant (12-1, 12-2) respectif entre les courants individuels (10-1, 10-2) détectés et le courant total (10-s) détecté,

détermination de limites de courant individuel maximales (15-1, 15-2) du système de batteries, respectivement pour chacune des au moins deux batteries, en se basant sur le rapport de courant (12-1, 12-2) respectivement déterminé et sur une limite de courant maximale nominale (30-1, 30-2) de la batterie respective ;

et/ou

réception ou estimation d'une résistance individuelle (11-1, 11-2) respective des au moins deux batteries,

réception ou estimation d'une résistance totale (11-s) du système de batteries,

détermination d'un rapport de résistance (13-1, 13-2) respectif entre les résistances individuelles (11-1, 11-2) reçues ou estimées et la résistance totale (11-s) reçue ou estimée,

détermination de limites de courant individuel maximales (15-1, 15-2) du système de batteries, respectivement pour chacune des au moins deux batteries, à partir du rapport de résistance (13-1, 13-2) respectivement déterminé et d'une limite de courant maximale nominale (30-1, 30-2) de la batterie respective ;

sélection de la plus petite limite de courant individuel maximale (15-1, 15-2) déterminée comme limite de courant maximale (40) du système de batteries,

fourniture de la limite de courant maximale (40) déterminée en tant que signal de limite de courant maximale (41).

7. Appareil de commande (1) selon la revendication 6, **caractérisé en ce que** l'appareil de commande (1) est en outre conçu pour former une valeur moyenne pondérée (14-1, 14-2) à partir du rapport de courant (12-1, 12-2) et du rapport de résistance (13-1, 13-2) respectifs et pour déterminer les limites de courant individuel maximales (15-1, 15-2) à partir de la valeur moyenne pondérée (14-1, 14-2) respective.

8. Appareil de commande (1) selon la revendication 7, **caractérisé en ce que** l'appareil de commande (1) est en outre conçu pour sélectionner des facteurs de pondération lors de la formation de la valeur moyenne pondérée (14-1, 14-2) en fonction du courant total (10-s).

9. Appareil de commande (1) selon l'une des revendications 6 à 8, **caractérisé en ce que** l'appareil de commande (1) présente un dispositif de filtrage (2) destiné à filtrer les rapports de courant (12-1, 12-2) et/ou les rapports de résistance (13-1, 13-2) et/ou les valeurs moyennes pondérées (14-1, 14-2) temporellement au moyen d'un filtre passe-bas, dans lequel l'appareil de commande (1) est en outre conçu pour déterminer les limites de courant individuel maximales (15-1, 15-2) à partir des rapports filtrés et/ou des valeurs moyennes pondérées filtrées (16-1, 16-2).

10. Commande de système de batteries (60), comprenant au moins un appareil de commande (1) selon l'une des revendications 6 à 9, dans laquelle la commande de système de batteries (60) est destinée à limiter un courant total (10-s) du système de batteries à partir d'une limite de courant maximale (40) déterminée au moyen de l'appareil de commande (1).

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2019214837 A1